(19) Europäisches Patentamt / European Patent Office / Office européen des brevets

(11) **EP 3 341 978 B1**

(12) **FASCICULE DE BREVET EUROPEEN**

(45) Date de publication et mention
de la délivrance du brevet:
**29.04.2020 Bulletin 2020/18**

(21) Numéro de dépôt: **16766996.9**

(22) Date de dépôt: **23.08.2016**

(51) Int Cl.:
***H01L 39/14*** *(2006.01)*

(86) Numéro de dépôt international:
**PCT/FR2016/052105**

(87) Numéro de publication internationale:
**WO 2017/037361 (09.03.2017 Gazette 2017/10)**

(54) **PROCÉDÉ DE CONTRÔLE DE DÉPLACEMENT D'UN VORTEX D'ABRIKOSOV**

KONTROLLVERFAHREN FÜR EINE VERLAGERUNG EINES ABRIKOSOV WIRBELS

CONTROL METHOD FOR A DISPLACEMENT OF AN ABRIKOSOV VORTEX

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.08.2015 FR 1558027**

(43) Date de publication de la demande:
**04.07.2018 Bulletin 2018/27**

(73) Titulaires:
• **Centre National de la Recherche Scientifique (CNRS)**
**75016 Paris (FR)**
• **Université de Bordeaux**
**33000 Bordeaux (FR)**

(72) Inventeurs:
• **BOUZDINE, Alexandre**
**33170 Gradignan (FR)**
• **LOUNIS, Brahim**
**33600 Pessac (FR)**
• **TAMARAT, Philippe**
**33670 Cursan (FR)**

(74) Mandataire: **Lavoix**
**2, place d'Estienne d'Orves**
**75441 Paris Cedex 09 (FR)**

(56) Documents cités:
• **T PUIG ET AL: "Laser induced nanosecond flux motion in YBa2Cu3O7-d films", SOLID STATE COMMUNICATIONS, vol. 101, no. 10, 1 mars 1997 (1997-03-01) , pages 761-765, XP055310734, GB ISSN: 0038-1098, DOI: 10.1016/S0038-1098(96)00685-0**
• **DANIEL GOLUBCHIK ET AL: "Mass of a vortex in a superconducting film measured via magneto-optical imaging plus ultrafast heating and cooling", PHYSICAL REVIEW. B, CONDENSED MATTER AND MATERIALS PHYSICS, vol. 85, no. 6, 13 février 2012 (2012-02-13), pages 060504/1-4, XP055310866, US ISSN: 1098-0121, DOI: 10.1103/PhysRevB.85.060504**
• **HUEBENER R P ET AL: "Thermoelectric and thermomagnetic effects in the mixed state of HTSC's", PHYSICA C, NORTH-HOLLAND PUBLISHING, AMSTERDAM, NL, vol. 185-189, 1 décembre 1991 (1991-12-01) , pages 349-354, XP027276866, ISSN: 0921-4534 [extrait le 1991-12-01]**

**Description**

L'invention a pour objet un procédé de contrôle de déplacement d'un vortex d'Abrikosov d'un élément constitué d'un matériau supraconducteur, dit élément supraconducteur.

Il est connu qu'un élément supraconducteur de type II laisse pénétrer un champ magnétique de valeur comprise entre un premier champ critique et un deuxième champ critique sous la forme de vortex d'Abrikosov.

Un vortex d'Abrikosov est un tube de flux magnétique autour duquel circule un courant.

Un élément supraconducteur présente des propriétés physiques spécifiques, particulièrement lorsqu'il est compris dans une jonction Josephson.

Une jonction Josephson est réalisée par exemple par un tricouches d'empilement de deux couches minces de l'élément supraconducteur et séparées par un lien faible.

Le lien faible est constitué notamment par une couche mince d'un matériau isolant ou d'un métal.

Dans une telle jonction Josephson, il existe un courant sans qu'aucune différence de potentiel ne soit appliquée, dû à un passage de paires de Cooper de spins des électrons supraconducteurs par effet tunnel à travers la barrière que constitue le lien faible.

Le courant maximal qui peut parcourir la jonction est appelé courant critique.

Les jonctions Josephson ont permis des avancées technologiques importantes, comme par exemple la mise au point de détecteurs de champ magnétique de type SQUID.

Une autre application importante des jonctions Josephson est le stockage d'information et permet de surcroit de générer un bit quantique, ou qubit.

Il a été démontré que le courant critique d'une jonction Josephson est fortement influencé par la présence de vortex dans son voisinage proche, et peut en particulier être réduit fortement selon la distribution des vortex dans les couches supraconductrices de la jonction Josephson.

Pour surmonter cette difficulté, il est connu de modifier la distribution globale des vortex dans les couches supraconductrices, par exemple via une application contrôlée de champ magnétique.

Néanmoins, cette approche globale ne permet pas de contrôler un déplacement d'un vortex unique.

Récemment, il a été démontré la possibilité de déplacer un vortex unique par microscopie à force magnétique.

Toutefois, cette méthode présente l'inconvénient de ne permettre qu'un déplacement lent du vortex et, de surcroit, à très faible échelle seulement.

Un autre inconvénient réside dans le fait qu'une force appliquée par le microscope sur le vortex s'avère souvent inférieure à une force de piégeage du vortex dans l'élément supraconducteur, et qu'alors, le déplacement du vortex par cette méthode est irréalisable.

Dans l'article de R.P. HUEBENER et al., "Thermoelectric and thermomagnetic effects in the mixed state of HTSC's", PHYSICA C, NORTH-HOLLAND PUBLISHING, AMSTERDAM, NL, vol. 185-189, 1 décembre 1991 (1991-1201), pages 349-354, les auteurs cherchent à identifier les diverses forces qui s'appliquent à un vortex dans les phénomènes de diffusion thermique. Est en particulier identifiée une force thermique de diffusion due à l'effet NERNST. Celle-ci est proportionnelle au gradient de température, mais orientée des températures hautes vers les températures. Il est aussi fait référence à l'article de

DANIEL GOLUBCHIK ET AL: "Mass of a vortex in a superconducting film measured via magneto-optical imaging plus ultrafast heating and cooling",PHYSICAL REVIEW. B, CONDENSED MATTER AND MATERIALS PHYSICS, vol. 85, no. 6, 13 février 2012 (2012-02-13), pages 060504/1-4, ,US ISSN: 1098-0121, DOI: 10.1103/ PhysRevB.85.060504

Le but de l'invention est de remédier au moins partiellement à ces inconvenients.

A cet effet, l'invention a pour objet un procédé selon la revendication indépendante de procédé 1.

Grâce à la présente invention, du fait que le chauffage est inhomogène, un gradient de température est généré et le vortex est attiré vers la zone la plus chaude, c'est-à-dire la zone de chauffage, vers laquelle il se déplace.

Ainsi, il suffit de générer la zone chaude vers l'endroit où l'on souhaite positionner le vortex, ce qui assure le déplacement contrôlé du vortex.

Selon une autre caractéristique de l'invention, au cours de l'étape de chauffage inhomogène de l'élément supraconducteur, on chauffe la zone de chauffage par application d'un faisceau laser.

Selon une autre caractéristique de l'invention, le procédé comprend une étape de focalisation du faisceau laser dans la zone de chauffage.

Selon une autre caractéristique de l'invention, au cours de l'étape de chauffage, le faisceau laser génère une force d'attraction du vortex d'une valeur :

$$f_T = -\frac{\Phi_0}{4\pi} * \frac{\partial H_{c1}}{\partial T} * |\nabla T|,$$ où $\Phi_0$ est un quantum de flux magnétique, $H_{c1}$ est un premier champ critique de l'élément supraconducteur, et $T$ est une température associée au faisceau laser.

Selon une autre caractéristique de l'invention, le vortex d'Abrikosov se déplace vers la zone de chauffage si la force d'attraction générée par le faisceau laser est supérieure à une force de piégeage du vortex d'Abrikosov dans l'élément supraconducteur.

Selon une autre caractéristique de l'invention, la force de piégeage est égale à :
$F_p = j_c\Phi_0$, où $\Phi_0$ est un quantum de flux magnétique et $j_c$ est un courant critique de l'élément supraconducteur.

Selon une autre caractéristique de l'invention, une puissance du laser est comprise entre 1 µW et 1000 µW.

Selon une autre caractéristique de l'invention, une longueur d'onde du laser est comprise dans le spectre électromagnétique visible.

Selon une autre caractéristique de l'invention, le procédé comprend une étape de détermination de la valeur de la force de piégeage par une force minimale à appliquer par le faisceau laser pour que le vortex d'Abrikosov se déplace.

L'invention a également pour objet une utilisation du procédé de contrôle tel que décrit précédemment pour former d'une distribution de vortex dans un élément supraconducteur, dans laquelle on applique le procédé tel que décrit précédemment à l'un au moins des vortex d'une distribution initiale de vortex.

De préférence, on applique le procédé tel que décrit précédemment successivement à chaque vortex de la distribution de vortex.

Avantageusement, on prévoit une étape d'évitement de collision entre le vortex déplacé par le procédé tel que décrit précédemment et les autres vortex de la distribution de vortex.

L'invention a également pour objet un procédé de contrôle tel que décrit précédemment à une jonction Josephson munie d'un vortex d'Abrikosov pour contrôler une valeur d'un courant critique de ladite jonction Josephson.

L'invention a également pour objet une utilisation du procédé tel que décrit précédemment pour un stockage d'information dans laquelle une écriture d'information est réalisée par le déplacement du vortex d'Abrikosov.

L'invention a également pour objet un programme d'ordinateur comprenant une suite d'instructions mettant en œuvre les étapes du procédé tel que décrit précédemment lorsqu'elles sont exécutées par un processeur.

L'invention a également pour objet un support de stockage non transitoire lisible par ordinateur comprenant un programme d'ordinateur tel que décrit précédemment.

D'autres caractéristiques et avantages de l'invention apparaîtront encore à la lecture de la description qui va suivre. Celle-ci est purement illustrative et doit être lue en regard des dessins annexés sur lesquels :

- la figure 1 illustre une représentation schématique d'un système de mise en œuvre d'un procédé de contrôle de déplacement d'un vortex d'Abrikosov selon la présente invention ;
- la figure 2 illustre une vue en coupe transversale d'un échantillon d'un élément supraconducteur pour le système de la figure 1 ;
- la figure 3 illustre une vue en perspective d'un déplacement d'un vortex d'Abrikosov par un faisceau laser du système de la figure 1 ;
- les figures 4a, 4b et 4c illustrent une séquence expérimentale de déplacement de chaque vortex d'un ensemble de vortex par le système de la figure 1 ;
- la figure 5 illustre un histogramme d'un rapport d'un nombre ($N_d$) de vortex déplacés par le faisceau laser de la figure 1 sur l'ensemble de neuf vortex (N) des figures 4a, 4b et 4c en fonction d'une puissance du faisceau laser à trois températures différentes, $T =$ 7,5 K, $T =$ 6,5 K et $T =$ 4,7 K ;
- la figure 6a illustre une distribution initiale de vortex dans un échantillon ; et
- la figure 6b illustre une distribution de vortex après déplacement par le procédé selon la présente invention.

## Système pour la mise en œuvre d'un procédé de contrôle de déplacement d'un vortex d'Abrikosov

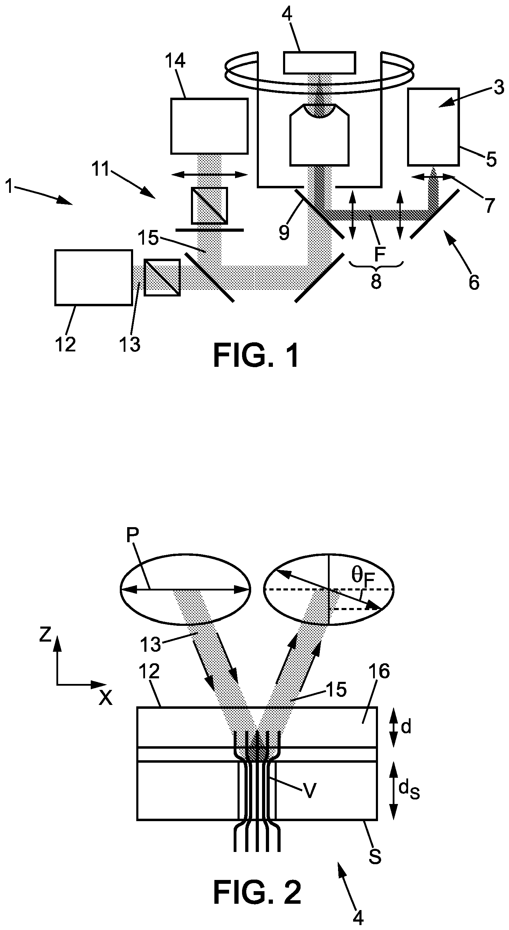

Comme visible sur la figure 1, un système 1 pour la mise en œuvre d'un procédé de contrôle de déplacement 2 d'un vortex d'Abrikosov selon la présente invention comprend une source thermique 3 appliquée sur un échantillon 4 d'un élément supraconducteur.

La source thermique 3 est configurée pour chauffer de manière inhomogène l'échantillon 4, comme il sera détaillé ultérieurement.

Sur le mode de réalisation illustré, la source thermique 3 de chauffage inhomogène est un laser 5 apte à émettre un faisceau laser F.

Comme visible sur la figure 1, le système 1 comprend des moyens de mise en forme 6 du faisceau laser comprenant une lentille de collimation 7 du laser 5 et une optique télécentrique 8.

Les moyens de mise en forme comprennent également un diviseur de faisceau 9.

Les moyens de mise en forme 6 permettent de focaliser le faisceau laser sur une zone déterminée de l'échantillon 4, dite zone de chauffage 10, comme il va être expliqué.

Le système 1 comprend également des moyens d'imagerie 11 pour visualiser un suivi des déplacements du vortex d'Abrikosov.

Comme visible sur la figure 1, les moyens d'imagerie 11, de préférence de type magnéto-optique, comprennent une source de lumière incidente 12, par exemple une source de lumière blanche, dirigée sur une face externe de l'échantillon 4.

La lumière incidente 13 émise par la source de lumière incidente 12 présente une polarisation rectiligne P selon une direction appelée X.

Les moyens d'imagerie 11 comprennent également un élément de visualisation 14, tel qu'une caméra CCD, orientée pour recevoir un faisceau lumineux 15 émis par la source 12 et réfléchi par l'échantillon 4, comme il va être expliqué.

Le système 1 comprend également un dispositif de refroidissement de l'échantillon 4, non illustré.

Le système 1 comprend également un dispositif d'application d'un champ magnétique à l'échantillon 4, non illustré.

Bien entendu, l'invention ne se limite pas au système de mise en œuvre 1 illustré et d'autres systèmes peuvent être utilisés pour le procédé 2 selon la présente invention.

Par exemple, selon une variante, le système de mise en œuvre se présente sous la forme d'un fil comprenant un microcontact pour chauffer l'échantillon 4 à distance suffisante du vortex.

Echantillon

L'échantillon 4 comprend une couche mince, appelée par la suite film, de l'élément supraconducteur S.

L'élément supraconducteur S est de type II, c'est-à-dire que, lorsque la température appliquée à l'échantillon 4 par le dispositif de refroidissement est inférieure à une température de transition supraconductrice, notée $T_c$, un champ magnétique appliqué par le dispositif d'application d'un champ magnétique pénètre sous la forme de vortex d'Abrikosov si le champ magnétique appliqué est compris entre un premier champ magnétique critique $H_{c1}$ et un second champ magnétique critique $H_{c2}$.

Comme déjà indiqué, un vortex d'Abrikosov est un tube de flux magnétique autour duquel circule un courant.

Par la suite, on fait référence au vortex d'Abrikosov sous le terme vortex V.

Sur le mode de réalisation illustré à la figure 2, le film supraconducteur est un film de niobium (Nb) présentant une épaisseur $d_S$.

Avantageusement, le film de niobium est déposé sur un substrat, par exemple de $SiO_2$/Si, non illustré.

De préférence, le dépôt de niobium sur le substrat est réalisé par une technique de pulvérisation cathodique magnétron, connue de l'homme du métier.

Comme visible sur la figure 2, l'échantillon 4 comprend également une couche d'indication visuelle 16.

La couche d'indication visuelle 16 est configurée pour modifier la polarisation de la lumière incidente 13, comme il va être expliqué, ce qui permet le suivi visuel du déplacement du vortex V par les moyens d'imagerie 11.

Sur la figure 2, la couche d'indicateur 16 est constituée à base d'un cristal de Bi:LuIG avec magnétisation planaire.

La couche de Bi:LuIG forme une face externe 17 de l'échantillon 4.

La lumière incidente 13 des moyens d'imagerie magnéto-optique 11 est dirigée sur la couche de Bi:LuIG 16 où la polarisation du faisceau est modifiée du fait d'un effet Faraday d'interaction entre la source lumineuse et un champ magnétique du vortex V.

Avantageusement, la polarisation du faisceau tourne de sorte qu'un angle entre la polarisation du faisceau réfléchi 15 et la polarisation du faisceau incident 13 est un angle $\theta_F = 2\vartheta B_Z d$, où $\vartheta$ est une constante de Verdet de la couche 16 de Bi:LuIG, $d$ est une épaisseur de la couche 16 de Bi:LuIG et $B_Z$ est une composante selon un axe Z du champ magnétique du vortex V.

Procédé de déplacement contrôlé de chaque vortex

Le procédé de contrôle de déplacement du vortex unique V selon la présente invention comprend une étape de chauffage inhomogène de l'élément supraconducteur S dans la zone de chauffage 10 de façon à déplacer le vortex V vers la zone de chauffage 10.

Par unique, on entend que le procédé 2 permet de contrôler le déplacement individuel de chaque vortex d'une distribution de vortex.

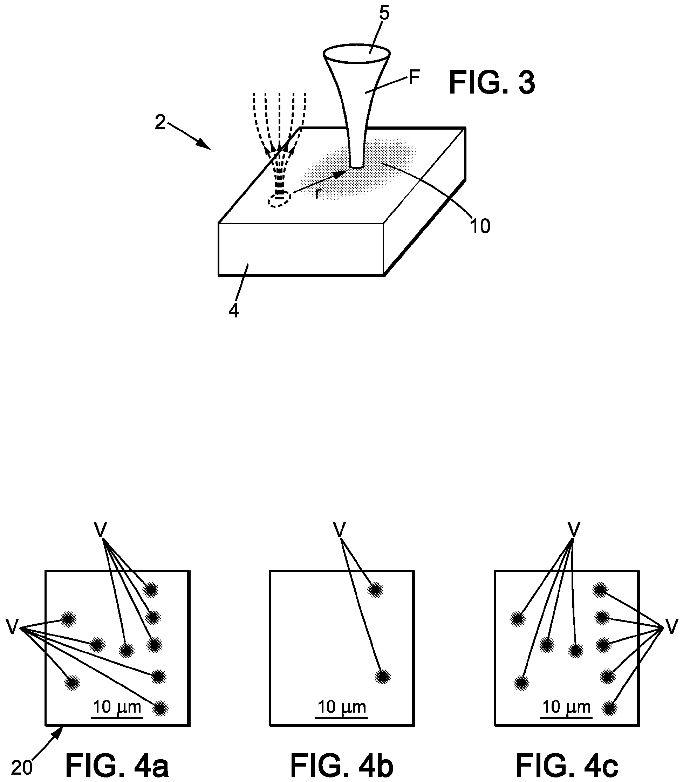

Comme visible sur la figure 3, le faisceau laser F est dirigé sur l'échantillon, ce qui crée la zone de chauffage 10.

Le laser est avantageusement focalisé sur la zone de chauffage 10.

Au cours de l'étape de chauffage, le faisceau laser F génère une force d'attraction du vortex V d'une valeur :

$$f_T = -\frac{\Phi_0}{4\pi} * \frac{\partial H_{c1}}{\partial T} * |\nabla T|,$$

où $\Phi_0$ est un quantum de flux magnétique, $H_{c1}$ est le premier champ critique de l'élément supraconducteur, $T$ est une température associée au faisceau laser et $\nabla T$ est le gradient de température généré depuis le faisceau laser.

On note que le gradient $\nabla T$ généré par le faisceau laser F dépend d'une distance entre la zone de chauffage 10 et du vortex V et de la puissance laser $P$ selon les lois de Fourier de la propagation de la chaleur dans l'échantillon 4.

La dérivée du premier champ critique $H_{c1}$ avec la température s'écrit :

$$\frac{\partial H_{c1}}{\partial T} = \frac{\Phi_0}{4\pi\lambda_0^2 T_c}(ln\kappa + 0{,}5),$$

où $\lambda_0$ est une longueur de pénétration magnétique dans le film supraconducteur, et $\kappa$ est un paramètre Ginzburg-Landu du film supraconducteur.

La force de piégeage s'exprime encore :

$$f_T = \left(\frac{\Phi_0}{4\pi\lambda_0}\right)^2 (ln\kappa + 0{,}5) \frac{\nabla T}{T_c}.$$

Le vortex V se déplace vers la zone de chauffage 10 si la force d'attraction générée par le faisceau laser F est supérieure à une force de piégeage du vortex d'Abrikosov dans l'élément supraconducteur par des centres de piégeage.

La force de piégeage est égale à : $F_p = j_c\Phi_0$, où $j_c$ est un courant critique de l'élément supraconducteur.

La force minimale de déplacement de vortex

$$f_T^{min}$$ est donc

$$\left(\frac{\nabla T}{T_c}\right)_{min} = \frac{(4\pi)^2}{(ln\kappa+0,5)} \frac{j_c\lambda_0^2}{\Phi_0}.$$

On note que le courant critique dépend de l'épaisseur $d_S$ du film supraconducteur S, ce qui implique que la force minimale dépend de l'épaisseur du film supraconducteur.

On note également que le courant critique, et par conséquent la force minimale, dépend également de la température appliquée à l'échantillon 4.

On note qu'une puissance maximale du faisceau laser est déterminée par une condition selon laquelle une taille du faisceau, en particulier un rayon du faisceau, est inférieure à une distance entre vortex, quand plusieurs vortex V sont générés dans le film supraconducteur.

Résultats expérimentaux

Expérience 1

Une première expérience a été menée selon le procédé 2, mis en œuvre par le système 1 sur l'échantillon 4.

Selon cette première expérience, le film de Nb de l'échantillon 4 présente une épaisseur $d_S$ de l'ordre de 450 nm.

La température est abaissée par le dispositif de refroidissement à une valeur de $T$ = 4,7 K inférieure à la température de transition $T_C$ = 8,4 K.

Un champ magnétique extérieur $H_{ext}$ est appliqué d'une valeur de $H_{ext}$ = 4,4 Oe.

Comme visible à la figure 4, il résulte de ces conditions de température et champ magnétique une distribution initiale 20 de vortex V.

De manière connue, les vortex V se positionnent dans l'échantillon 4 en fonction des centres de piégeage du film supraconducteur S.

Sur la figure 4a, neuf vortex V de la distribution initiale 20 sont illustrés.

Selon cette expérience, le laser 5 présente une puissance $P$ et un rayon $r_0$ de l'ordre de 0,4 $\mu$m.

Le faisceau laser F est dirigé vers la face externe 12 de l'échantillon 4.

Le faisceau laser F s'étend de préférence transversalement à un plan de la face externe 12.

Le faisceau laser F est focalisé sur la face externe 12, successivement à une distance $r$ = 4 $\mu$m de chaque vortex V de la distribution 21 de vortex V.

Le laser est d'une longueur d'onde visible, de l'ordre de 630 nm.

Le faisceau laser chauffe localement l'échantillon 4, ce qui crée la zone chaude 11.

Le chauffage par laser dure pendant 1 seconde.

Comme visible à la figure 4b, pour une puissance laser de 4,9 $\mu$W, deux vortex V se sont déplacés.

Comme visible sur la figure 4c, tous les vortex V se sont déplacés pour une puissance $P_{min}$ de l'ordre 7,3 $\mu$W.

Expérience 2

Les conditions expérimentales sont inchangées par rapport à la première expérience.

En particulier, l'échantillon 4 est identique à celui de la première expérience.

Le laser est identique à celui de la première expérience.

Le laser est focalisé à une distance $r$ = 4 $\mu$m de chaque vortex V de la distribution 21.

L'échantillon 4 est refroidi à trois températures $T$, $T$ = 7,5 K, $T$ = 6,5 K et $T$ = 4,7 K.

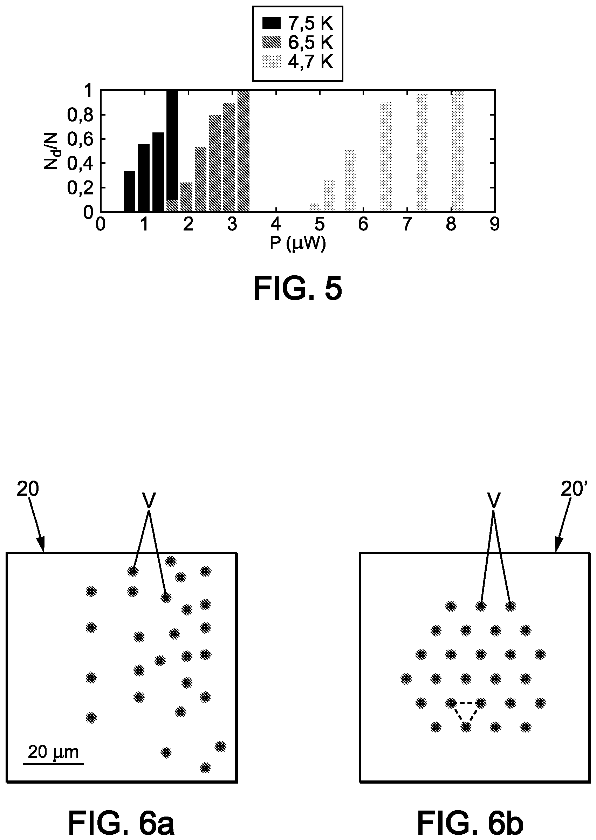

Comme visible sur la figure 5, à $T$ = 4,7 K, 100% des neuf vortex V se déplacent pour une puissance du laser supérieure ou égale à 7,2 $\mu$W.

A $T$ = 6,5 K, 100% des neuf vortex V se déplacent pour une puissance du laser supérieure ou égale à 3,3 $\mu$W.

A $T$ = 7,5 K, 100% des neuf vortex V se déplacent pour une puissance du laser supérieure ou égale à 1,8 $\mu$W.

On constate que plus la température est proche de la température de transition supraconductrice, moins la puissance minimale est élevée, ce qui est dû au fait que la force de piégeage augmente avec une diminution de la température appliquée.

Expérience 3

L'échantillon 4 est identique à celui de la première expérience.

Le laser est identique à celui de la deuxième expérience.

Le laser est focalisé à une distance $r$ = 1 $\mu$m de chaque vortex V de la distribution 20.

Dans ces conditions, à $T$ = 4,7 K, 100% des neuf vortex V se déplacent pour une puissance du laser supérieure ou égale à 6,5 $\mu$W.

Dans cette expérience, la puissance maximale mesurée est de l'ordre de 15 $\mu$W afin de ne pas dépasser la température de transition supraconductrice.

Une modélisation basée sur les lois de Fourier de la propagation de la chaleur dans l'échantillon 4 permet de déterminer que le gradient de température $\nabla T$ généré par le faisceau laser F à la puissance $P_{min}$ est de l'ordre de 2 K/$\mu$m.

Considérant que la longueur de pénétration magnétique dans le film supraconducteur $\lambda_0$ est égale à 90 nm, et le paramètre Ginzburg-Landau $\kappa$ est égal à 6, alors la force de piégeage est évaluée selon l'équation de l'ordre de 9 pN/ $\mu$m.

Une mesure indépendante du courant critique donne une valeur de $j_c = 0,7 \cdot 10^6$ A/cm$^2$, ce qui correspond à une force de piégeage de l'ordre de 14 pN/ $\mu$m.

On constate que les deux procédés donnent une valeur du même ordre de grandeur pour la force de piégeage, ce qui assure que le procédé 2 permet la détermination de la valeur du courant critique.

## Programme d'ordinateur

L'invention a également pour objet un programme d'ordinateur comprenant une suite d'instructions mettant en œuvre les étapes du procédé 2 lorsqu'elles sont exécutées par un processeur.

L'invention a également pour objet un support de stockage non transitoire lisible par ordinateur comprenant un programme d'ordinateur tel que décrit précédemment.

## Expérience 4

Sur la figure 6a est illustrée une autre distribution initiale 20 de vortex V, créée dans l'échantillon 4 sous un champ extérieur de l'ordre de 4,3 Oe.

Comme visible sur la figure 6b, le programme d'ordinateur basé sur le procédé 2 permet un réarrangement de la distribution initiale 20 en une distribution 20' souhaitée, triangulaire.

De préférence, le procédé comprend également une étape d'évitement de collision entre le vortex déplacé par le procédé 2 et les autres vortex de la distribution de vortex 20.

## Estimation numérique

Cette estimation numérique est basée sur la loi de Fourier par utilisation du logiciel Comsol Multiphysics (marque déposée).

Le film de Nb de l'échantillon 4 présente une épaisseur $d_S$ de l'ordre de 5 nm.

Le laser 5 présente une puissance P = 530 $\mu$W.

Le vortex se déplace sur une distance de 300 nm avec une constante de temps de 10 ps.

Cette estimation démontre que le procédé 2 selon la présente invention permet un déplacement de vortex à une fréquence de l'ordre de 100 GHz, ce qui est une valeur beaucoup plus élevée que les fréquences de déplacement connues de l'état de la technique.

Une telle fréquence de déplacement assure l'utilisation du procédé 2 pour un stockage d'information.

## Utilisations

Le procédé 2 s'applique tout particulièrement à une jonction Josephson munie d'un vortex d'Abrikosov pour contrôler une valeur du courant critique de la jonction Josephson.

Comme déjà indiqué, une jonction Josephson un multicouches, de préférence tricouches d'empilement de deux couches minces de l'élément supraconducteur séparées par un lien faible.

Le lien faible est constitué notamment par une couche mince d'un matériau isolant ou d'un métal.

Dans une telle jonction Josephson, il existe un courant sans qu'aucune différence de potentiel ne soit appliquée, dû à un passage de paires de Cooper de spins des électrons supraconducteurs par effet tunnel à travers la barrier que constitue le lien faible.

On rappelle que le courant critique est le courant maximal pouvant parcourir la jonction Josephson.

Grâce au procédé 2, il est possible de changer la valeur du courant critique par le déplacement du vortex, du fait que le courant critique de la jonction Josephson est fortement influencé par la présence de vortex dans son voisinage proche.

Le procédé selon la présente invention permet de contrôler le déplacement de chaque vortex d'un ensemble de vortex de manière fiable et rapide et s'applique avantageusement aux utilisations précédemment décrites (distribution de vortex, stockage d'information, jonction Josephson).

## Revendications

1. Procédé de contrôle de déplacement individuel de chaque vortex d'Abrikosov d'une distribution de vortex d'un élément (4), constitué d'un matériau supraconducteur, et une couche d'indication visuelle (11), dit élément supraconducteur, la couche d'indication visuelle (11) étant configurée pour modifier la polarisation de la lumière incidente (13), comprenant une étape de chauffage inhomogène de l'élément supraconducteur muni du vortex d'Abrikosov dans une zone de chauffage de façon à déplacer le vortex d'Abrikosov vers la zone de chauffage.

2. Procédé de contrôle selon la revendication 1, dans lequel, au cours de l'étape de chauffage inhomogène de l'élément supraconducteur, on chauffe la zone de chauffage par application d'un faisceau laser.

3. Procédé de contrôle selon la revendication 2, comprenant une étape de focalisation du faisceau laser dans la zone de chauffage.

4. Procédé de contrôle selon l'une des revendications 2 ou 3, dans lequel, au cours de l'étape de chauffage, le faisceau laser génère une force d'attraction du

$$f_T = -\frac{\Phi_0}{4\pi} * \frac{\partial H_{c1}}{\partial T} * |\nabla T|,$$

vortex d'une valeur :

où $\Phi_0$ est un quantum de flux magnétique, $H_{c1}$ est un premier champ critique de l'élément supraconducteur, et $T$ est une température associée au faisceau laser.

5. Procédé de contrôle selon la revendication précédente, dans lequel le vortex d'Abrikosov se déplace vers la zone de chauffage si la force d'attraction générée par le faisceau laser est supérieure à une force de piégeage du vortex d'Abrikosov dans l'élément supraconducteur.

6. Procédé de contrôle selon la revendication précédente, dans lequel la force de piégeage est égale à : $F_p = j_c \Phi_0$, où $\Phi_0$ est un quantum de flux magnétique et $j_c$ est un courant critique de l'élément supraconducteur.

7. Procédé de contrôle selon l'une quelconque des revendications 2 à 6, dans lequel une puissance du laser est comprise entre 1 μW et 1000 μW.

8. Procédé de contrôle selon l'une quelconque des revendications 2 à 7, dans lequel une longueur d'onde du laser est comprise dans le spectre électromagnétique visible.

9. Procédé de contrôle selon l'une quelconque des revendications 5 à 8, comprenant une étape de détermination de la valeur de la force de piégeage par une force minimale à appliquer par le faisceau laser pour que le vortex d'Abrikosov se déplace.

10. Utilisation du procédé de contrôle selon l'une des revendications précédentes pour former une distribution de vortex dans un élément supraconducteur, dans laquelle on applique le procédé selon l'une quelconque des revendications précédentes à l'un au moins des vortex d'une distribution initiale de vortex.

11. Utilisation selon la revendication précédente, dans laquelle on applique le procédé selon l'une quelconque des revendications 1 à 9 successivement à chaque vortex de la distribution de vortex.

12. Utilisation selon l'une des revendications 10 ou 11, comprenant une étape d'évitement de collision entre le vortex déplacé par le procédé selon l'une des revendications 1 à 9 et les autres vortex de la distribution de vortex.

13. Utilisation du procédé de contrôle selon l'une des revendications 1 à 9 à une jonction Josephson munie d'un vortex d'Abrikosov pour contrôler une valeur d'un courant critique de ladite jonction Josephson.

14. Utilisation du procédé de contrôle selon l'une des revendications 1 à 9 pour un stockage d'information dans laquelle une écriture d'information est réalisée par le déplacement du vortex d'Abrikosov.

15. Programme d'ordinateur comprenant une suite d'instructions mettant en œuvre les étapes du procédé selon l'une des revendications 1 à 9 lorsqu'elles sont exécutées par un processeur.

16. Support de stockage non transitoire lisible par ordinateur comprenant un programme d'ordinateur selon la revendication précédente.

**Patentansprüche**

1. Verfahren zur Kontrolle der einzelnen Verlagerung jedes Abrikossow-Vortex einer Wirbelverteilung eines Elements (4) ("Supraleiterelement"), das aus einem Supraleitermaterial und einer Sichtanzeigeschicht (11) besteht, wobei die Sichtanzeigeschicht (11) derart konfiguriert ist, dass sie die Polarisation des Auflichtes (13) ändert,
umfassend inhomogenes Heizen des Supraleiterelements mit dem Abrikossow-Vortex in einem Heizbereich, so dass der Abrikossow-Vortex in Richtung des Heizbereichs verlagert wird.

2. Verfahren nach Anspruch 1, wobei im Schritt des inhomogenen Heizens des Supraleiterelements der Heizbereich durch die Anwendung eines Laserstrahls geheizt wird.

3. Verfahren nach Anspruch 2, umfassend Fokussieren des Laserstrahls im Heizbereich.

4. Verfahren nach einem der Ansprüche 2 oder 3, wobei im Heizschritt der Laserstrahl eine auf den Vortex gerichtete Anziehungskraft mit folgendem Wert erzeugt:
$$f_T = -\frac{\Phi_0}{4\pi} * \frac{\partial H_{c1}}{\partial T} * |\nabla T|$$
wobei $\Phi 0$ ein magnetisches Flussquantum ist, $H_{c1}$ ein erstes kritisches Feld des Supraleiterelements ist und T eine dem Laserstrahl zuzuordnende Temperatur ist.

5. Verfahren nach vorstehendem Anspruch, wobei sich der Abrikossow-Vortex hin zum Heizereich verlagert, wenn die vom Laserstrahl erzeugte Anziehungskraft größer ist als eine Pinning-Kraft des Abrikossow-Vortex im Supraleiterelement.

6. Verfahren nach vorstehendem Anspruch, wobei die Pinning-Kraft gleich $F_p = j_c \Phi_0$, ist, wobei $\Phi_0$ ein magnetisches Flussquantum ist und jc ein kritischer Strom des Supraleiterelements ist.

7. Verfahren nach einem der Ansprüche 2 - 6, wobei eine Leistung des Lasers zwischen 1 und 1000 μW liegt.

8. Verfahren nach einem der Ansprüche 2 - 7, wobei eine Wellenlänge des Lasers im sichtbaren elektromagnetischen Spektrum liegt.

9. Verfahren nach einem der Ansprüche 5 - 8, umfassend Ermitteln des Werts der Pinning-Kraft für eine vom Laserstrahl zur Verlagerung des Abrikossow-Vortex anzuwendende minimale Kraft.

10. Verwendung des Verfahrens nach einem der vorstehenden Ansprüche zur Bildung einer Wirbelverteilung in einem Supraleiterelement, wobei das Verfahren nach einem der vorstehenden Ansprüche auf mindestens einen Vortex einer anfänglichen Wirbelverteilung angewendet wird.

11. Verwendung nach vorstehendem Anspruch, wobei das Verfahren nach einem der Ansprüche 1 - 9 sukzessiv auf jeden Vortex der Wirbelverteilung angewendet wird.

12. Verwendung nach einem der Ansprüche 10 oder 11, umfassend Vermeiden einer Kollision zwischen dem durch das Verfahren nach einem der Ansprüche 1 - 9 verlagerten Vortex und den übrigen Vortizes der Wirbelverteilung.

13. Verwendung des Verfahrens nach einem der Ansprüche 1 - 9 auf einen Josephson-Übergang mit Abrikossow-Vortex, um einen Wert eines kritischen Stroms des Josephson-Übergangs zu kontrollieren.

14. Verwendung des Verfahrens nach einem der Ansprüche 1 - 9 zur Speicherung von Informationen, wobei die Informationen durch die Verlagerung des Abrikossow-Vortex geschrieben werden.

15. Computerprogramm, umfassend eine Befehlsfolge, die bei Ausführung durch einen Prozessor die Schritte des Verfahrens nach einem der Ansprüche 1 - 9 ausführt.

16. Nicht flüchtiger computerlesbarer Datenträger, umfassend ein Computerprogramm nach vorstehendem Anspruch.

## Claims

1. Control method of an individual displacement of each Abrikosov vortex of a vortex distribution of an element (4), made up of a superconducting material and a visual indicator layer (11), called superconducting element, the visual indicator layer (11) being configured to modify the polarization of the incident light (13), comprising a step for inhomogeneous heating of the superconducting element provided with the Abrikosov vortex in a heating zone so as to displace the Abrikosov vortex toward the heating zone.

2. The control method according to claim 1, wherein, during the step for inhomogeneous heating of the superconducting element, the heating zone is heated by applying a laser beam.

3. The control method according to claim 2, comprising a step for focusing the laser beam in the heating zone.

4. The control method according to one of claims 2 or 3, wherein, during the heating step, the laser beam generates an attraction force of the vortex with a value:
$$f_T = -\frac{\Phi_0}{4\pi} * \frac{\partial H_{C1}}{\partial T} * |\nabla T|,$$
where $\varphi_0$ is a magnetic flux quantum, $H_{C1}$ is a first critical field of the superconducting element, and $T$ is a temperature associated with the laser beam.

5. The control method according to the preceding claim, wherein the Abrikosov vortex moves toward the heating zone if the attraction force generated by the laser beam is greater than a trapping force of the Abrikosov vortex in the superconducting element.

6. The control method according to the preceding claim, wherein the trapping force is equal to:
$F_p = j_c\Phi_0$, where $\Phi_0$ is a magnetic flux quantum and $j_C$ is a critical current of the superconducting element.

7. The control method according to any one of claims 2 to 6, wherein a power of the laser is between 1 $\mu$W and 1000 $\mu$W.

8. The control method according to any one of claims 2 to 7, wherein a wavelength of the laser is comprised in the visible electromagnetic spectrum.

9. The control method according to any one of claims 5 to 8, comprising a step for determining the value of the trapping force by a minimum force to be applied by the laser beam in order for the Abrikosov vortex to be displaced.

10. A use of the control method according to one of the preceding claims to form a vortex distribution in a superconducting element, in which the method according to any one of the preceding claims is applied to at least one of the vortexes of an initial vortex distribution.

11. The use according to the preceding claim, wherein the method according to any one of claims 1 to 9 is applied successively to each vortex of the vortex distribution.

12. The use according to one of claims 10 or 11, comprising a step for collision avoidance between the vortex displaced by the method according to one of claims 1 to 9 and the other vortexes of the vortex distribution.

13. The use of the control method according to one of claims 1 to 9 in a Josephson junction provided with an Abrikosov vortex in order to control a value of a critical current of said Josephson junction.

14. The use of the control method according to one of claims 1 to 9 in order to store information in which information writing is done by the displacement of the Abrikosov vortex.

15. A computer program comprising a series of instructions implementing the steps of the method according to one of claims 1 to 9 when they are executed by a processor.

16. A computer-readable non-transient storage medium comprising a computer program according to the preceding claim.

**FIG. 1**

**FIG. 2**

FIG. 3

FIG. 4a

FIG. 4b

FIG. 4c

**FIG. 5**

**FIG. 6a**

**FIG. 6b**

## RÉFÉRENCES CITÉES DANS LA DESCRIPTION

### Littérature non-brevet citée dans la description

- **R.P. HUEBENER et al.** Thermoelectric and thermomagnetic effects in the mixed state of HTSC's. PHYSICA C, NORTH-HOLLAND PUBLISHING, 01 Décembre 1991, vol. 185-189, 349-354

- **DANIEL GOLUBCHIK et al.** Mass of a vortex in a superconducting film measured via magneto-optical imaging plus ultrafast heating and cooling. *PHYSICAL REVIEW. B, CONDENSED MATTER AND MATERIALS PHYSICS,* 13 Février 2012, vol. 85 (6), ISSN 1098-0121, 060504, , 1-4